# EUROPEAN PATENT APPLICATION

(11) **EP 0 526 734 A2**
(43) Date of publication of application: **10.02.1993**
(21) Application number: 92111075.5
(22) Date of filing: 30.06.1992
(51) Int. Cl.: G01R 31/26, G01R 31/308

(54) **Noncontact probe and active matrix array inspection apparatus using the same**

(30) Priority: 04.07.1991 JP 164423/91; 05.07.1991 JP 165567/91
(71) Applicant: ADVANTEST CORPORATION, Nerima-Ku Tokyo (JP)
(72) Inventor: Kido, Takashi, Sapporo-shi, Hokkaido (JP)
(74) Representative: Hoffmann, Eckart, Dipl.-Ing.

(57) **Abstract**

Gate signal generating part (19G) and source signal generating part (19S) generate a square-wave gate signal and a square-wave source signal, respectively. Gate signal lines (Xₙ) of an active matrix array (11) are connected via a switching circuit (18G) to the output terminal of the gate signal generating part or a grounding terminal. Source signal lines (Yₙ) of the active matrix array are connected via a switching circuit (18S) to the output terminal of the source signal generating part or a grounding terminal. A laser light beam (Li) is applied to the drain of a selected one of the thin film transistors. A reflected light beam of a reflectance corresponding to the charge density at the point of incidence of the laser light beam to the drain of the thin film transistor is received and the intensity of the reflected light beam is detected as a signal representing the electrical state at the point of incidence of the light beam.

## Description

### BACKGROUND OF THE INVENTION

The present invention relates to a noncontact probe which irradiates a transistor, semiconductor integrated circuit or similar semiconductor device with an optical beam and detects its charge density (i.e. carrier density) or the corresponding electrical state in a noncontact manner.

With the recent trend toward large, high-definition liquid crystal display panels, the numbers of pixels and scanning lines have inevitably increased so large that conventional simple matrix display panels cannot achieve satisfactory contrast of display and response speed, and as a substitute therefor, an active-matrix liquid-crystal display panel of the type having a switching element disposed for each pixel has now come into common use. It is necessary, however, that thin film elements and thin film circuit, including a matrix array of more than tens of thousands of thin film transistors serving as switching elements, be formed on one substrate, as an active-matrix array for use in the active-matrix, liquid-crystal display panel. Highly advanced techniques are needed to manufacture the active-matrix array without any defects. With the present techniques, it is necessary to inspect the active matrix array for defects, decide whether each element is defective or non-defective, locate defective elements and repair them.

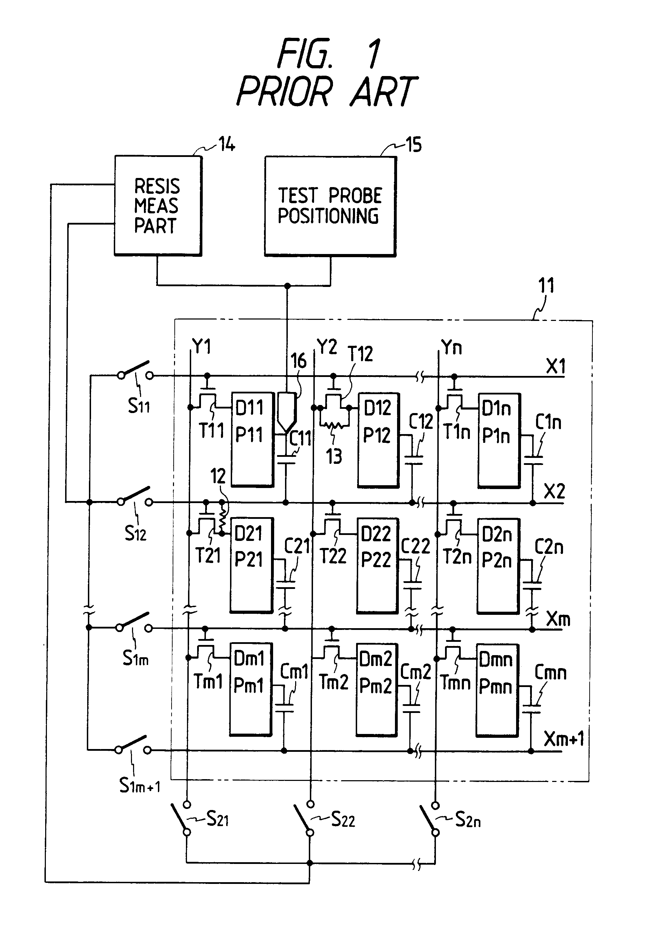

Fig. 1 shows an active-matrix array for use in the active-matrix liquid-crystal display panel. The active-matrix array includes a plurality of gate signal lines X₁ to Xm", a plurality of source signal lines Y₁ to Yₙ crossing them at right angles thereto and thin film transistors T11 to Tmn disposed at the intersecting points of the gate and source signal lines. The thin film transistors T11 to Tmn have their drain electrodes connected to pixel electrodes P11 to Pmn, respectively. The pixel electrodes P11 to Pmn have auxiliary capacitances C11 to Cmn formed between them and, for example, the gate signal lines X₁ to Xₘ₊₁, respectively.

For instance, when a shorting defect occurs between the gate and drain of the thin film transistor T21 as indicated by a resistor 12 in Fig. 1, the display state of the pixels connected to the gate and source signal lines to which the thin film transistor T21 is connected become abnormal, providing line defects in the display characteristic -- this seriously impairs the display quality. When a shorting defect 13 occurs between the source and drain of the thin film transistor T12 as shown in Fig. 1, the display state of the pixel associated with the thin film transistor T12 becomes abnormal due to the shorting, providing a point defect in the display characteristic. This also lowers the display quality. Hence it is important to detect malfunctioning portions where such line and point defects will develop and to repair them.

It is customary in the prior art to inspect the active matrix array by such a method as mentioned below. The gate signal lines X₁ to Xₘ₊₁ are connected to a resistance measuring part 14 via switches S11 to S₁ₘ₊₁, whereas the source signal lines Y₁ to Yₙ are also connected to the resistance measuring part 14 via switches S₂₁ to S₂ₙ. A test probe 16 is positioned by a test probe positioning unit 15 so that it makes contact with an arbitrary pixel electrode or a semiconductor portion connected thereto. The resistance measuring part 14 is connected to the test probe 16 as well and is able to measure the resistance value between a desired one of the gate or source signal lines and the pixel electrode connected to the drain terminal of an arbitrary one of the thin film transistors. In the following description the same reference characters and the same reference numerals will be used to identify the same parts.

In the case of detecting a defect between the gate and drain of the thin film transistor T11, the switch S₂₁ of the source signal line Y₁ is opened and the switch S₁₁ of the gate signal line X₁ is closed. Next, the test probe positioning unit 15 positions the test probe 15 into contact with the pixel electrode P11 connected to the drain terminal of the thin film transistor T11. Then, the resistance measuring part 14 measures the resistance value between the gate and drain of the thin film transistor T11. The defect can be detected from the resistance value thus measured. Similarly, in the case of checking the thin film transistor T21, the switch S₁₁ of the gate signal line X₁ is opened, the switch S12 ₂ of the gate signal line X₂ is closed, the test probe 16 is positioned in contact with the pixel electrode P12 connected to the drain terminal of the thin film transistor T21, and then the resistance value between its gate and drain. These operations are repeated for each of the thin film transistors T11 to Tm1. After checking them, the switch S₂₂ of the source signal line Y₂ is opened and the same operations as mentioned above are repeated for each of the thin film transistors T12 to Tm2 to measure the resistance value between the gate and drain of each thin film transistor. These operations are repeated until the resistance value between the gate and drain of the thin film transistor Tmn is measured.

Next, a description will be given of a method for detecting a defect between the source and drain of each thin film transistor. The first step is to open the switch S₁₁ of the gate signal line X₁ and close the switch S₂₁ of the source signal line Yi. Next, the test probe positioning unit 15 positions the test probe 16 in contact with the pixel electrode P11 connected to the drain terminal of the thin film transistor T11. Then, the resistance measuring part 14 measures the resistance value between the source and drain of the thin film transistor T11. The defect can be detected from the resistance value thus measured. Similarly, in the case of checking the thin film transistor T21 for a defect, the switch S₁₂ of the gate signal line X₂ is opened, the test probe 16 is positioned in contact with the pixel electrode P21 connected to the thin film transistor T21 and then the resistance value between its source and drain. These operations are repeated for each of the thin film transistors T11 to Tm1. After their inspection, the switch S₁₂ of the source signal line Y₁ is opened, the switch S₂₂ of the source signal line Y₂ is closed and then the same operations as mentioned above are repeated for the thin film transistor T12 to measure the resistance value between its source and drain. The above-mentioned operations are repeated until the thin film transistor Tmn is reached.

With such a method as mentioned above, however, the test probe 16 must be brought into direct contact with the pixel electrode connected to the drain or drain terminal of the thin film transistor being checked, and hence there is a possibility that the surface of the active matrix array is damaged, besides defects are likely to be left undetected due to bad contact of the test probe 16 with the pixel electrodes. In addition, the prior art method involves entirely mechanical positioning of the test probe 16 for the detection of defects, and hence consumes an enormous amount of time for positioning the probe 16.

In Japanese Patent Application Laid-Open Gazette No. 182578/88 there is set forth a method of detecting defects without directly contacting thin film transistors (TFTs) or pixel electrodes of active-matrix liquid-crystal display panels. In the official gazette it is proposed to actually drive every display element and detect its display state optically. With this method, it is possible to detect display defects of a completed liquid crystal display panel (i.e. a display panel having liquid crystal sealed between a pair of opposed transparent base plates or substrates), but the method cannot be used to inspect a TFT matrix array formed on a transparent substrate before assembling into a panel. That is, the method permits detection of display defects of completed display panels but is not capable of repairing or compensating for the defects.

As a means for inspecting semiconductor devices in a noncontact manner through utilization of an optical beam, there is known a laser probe described in Japanese Patent Application Laid-Open Gazette No. 2552/87, for instance. With the laser probe, as shown in Fig. 2, a laser beam L_{;} from a laser beam source 22 is applied to the surface of a semiconductor device 11. In the case where the semiconductor device 11 is, for example, a bipolar transistor, the laser beam L_{;} is applied to a base-collector junction at the boundary between base and collector regions of the semiconductor device 11 and a photo current appearing at its power supply terminal is measured, by which it is possible to analyze the electrical state (ON/OFF) of the transistor 11 during irradiation with the laser beam L_{;}. That is, in the semiconductor device 11 electron-hole pairs are excited by the irradiation with the laser beam and a photo current Ip corresponding to the electrical state of the semiconductor device 11 flows through the semiconductor device 11 and a photo current detector 17 and then into a drive power supply 21 of the semiconductor device 11. The photo current Ip is measured by the photo current detector 17 and the measured result is provided to a signal processing part 33, wherein it is used to decide the electrical state (ON/OFF) of the semiconductor device 11 at the point irradiated by the laser beam. The semiconductor device 11 is placed under control of a signal from a signal generator 19. With such an arrangement, it is possible to probe the electrical state of the semiconductor device 11 in a noncontact manner.

Such a laser probe permits noncontact inspection of the electrical state of the semiconductor device with a high spatial or positional resolution but possesses such disadvantages as mentioned below. The laser probe of the above construction can only decide the ON/OFF state of the semiconductor device but cannot measure its intermediate or transient state; namely, it is poor in voltage resolution. Furthermore, time resolution is limited by the time until the photo current reaches the photo current detector after diffusing through the semiconductor device, and the time resolution is tens of nanoseconds at maximum; hence, highspeed variations cannot be detected. Since electron-hole pairs are generated by laser irradiation for measurement, turbulence is caused in the semiconductor device accordingly, introducing the possibility of, for example, the OFF state being detected as the ON state. Where the region to be measured is inside the semiconductor, no photo current can be measured because the laser light does not permeate into the semiconductor.

### SUMMARY OF THE INVENTION

It is a first object of the present invention to provide a noncontact probe which permits detection of the operative state or potential condition of a semiconductor device at a desired position with high voltage resolution.

A second object of the present invention is to provide a semiconductor active matrix array inspection apparatus whereby an active matrix array exposed on a transparent substrate can be checked for defects by use of the above-mentioned noncontact probe.

According to the first aspect of the present invention, a light beam of a wavelength which does not excite electron-hole pairs is applied to a semiconductor device and, through utilization of a phenomenon that the light beam is reflected or transmitted on the basis of the refractive index corresponding to the charge density (or carrier density) of the semiconductor device in the irradiated region, a signal corresponding to the reflectance or refractive index is extracted from the reflected or transmitted light, whereby the charge density in the irradiated region, that is, its electrical state is detected.

For example, a light beam is applied to a semiconductor device and the reflected or transmitted light is converted by photodetector means into an electrical signal, from which is obtained a signal corresponding to the charge density in the semiconductor device at the position of incidence thereto of the light beam. Alternatively, a light beam is applied to the semiconductor device and is converted to an interference light beam of an intensity corresponding to the phase difference between the reflected or transmitted light and a reference light beam, and a signal corresponding to the charge density of the semiconductor device at the position of incidence thereto of the light beam is extracted from the converted electrical signal. That is, the light velocity varies with the refractive index of the semiconductor device and the refractive index corresponds to the charge density. Accordingly, the phase of the light beam varies with the charge density of the region through which the light passes, and based on the phase, a signal corresponding to the charge density of that region can be obtained.

The reference light beam is obtained by a method wherein a light beam from the light source is split into two, one of which is used as a measurement light beam and the other of which is applied to a predetermined position on a semiconductor device, and the reflected or transmitted light is used as the reference light. Another method is to apply one of two split light beams to an object of the same optical characteristics as those of the semiconductor device, for example, a simple silicon wafer, and use the reflected or transmitted light as the reference light beam. Still another method is to split the light beam from the light source into two, one of which is applied to the semiconductor device and the other of which is used directly as the reference light beam.

It is also possible to employ a method wherein the light beam from the light source is split into two, they are applied as first and second light beams to first and second positions on the semiconductor device, the reflected or transmitted light beams are converted by first and second photodetector means to first and second electrical signals, and the charge density of the semiconductor device at the first position relative to the charge density at the second position is detected from the first and second electrical signals.

Charges (or carriers) undergo a plasma oscillation at a plasma frequency dependent on their density. Accordingly, it is assumed here that the wavelength of the light beam incident to the semiconductor device is close to the plasma oscillation frequency to such an extent as to be influenced by the plasma oscillation.

According to the second aspect of the present invention, gate signal generating means and source signal generating means are provided, each gate signal line of an active matrix array under test is selectively switched between an output terminal of the gate signal generating means and a grounding terminal by gate signal line select means, and each source signal line is selectively switched between an output terminal of the source signal generating means and a grounding terminal by source signal select means. The electrical state at the drain terminal of a thin film transistor connected to gate and source signal lines is detected by a noncontact probe in a noncontact manner. The detected output is used to decide whether the thin film transistor is defective or not.

In the case where gate signal lines in the active matrix array are shorted by a shorting bar and source signal lines are similarly shorted by a shorting bar, the gate signal generating means is connected via a gate switch to the gate signal line shorting bar and the source signal generating means is also connected via a source switch to the source signal line shorting bar.

In the case of an active matrix array with drivers built therein, the gate signal generating means provides a signal which activates the built-in gate drive means to drive the gate signal lines in a sequential order, and the source signal generating means provides a signal which activates the built-in source drive means to drive the source signal lines one after another. The gate signal generating means is connected by gate switching means to the gate drive means and the source signal generating means is connected by source switching means to the source drive means.

### BRIEF DESCRIPTION OF THE DRAWINGS

Fig. 1 is a block diagram showing the construction of a conventional active matrix array inspection apparatus;

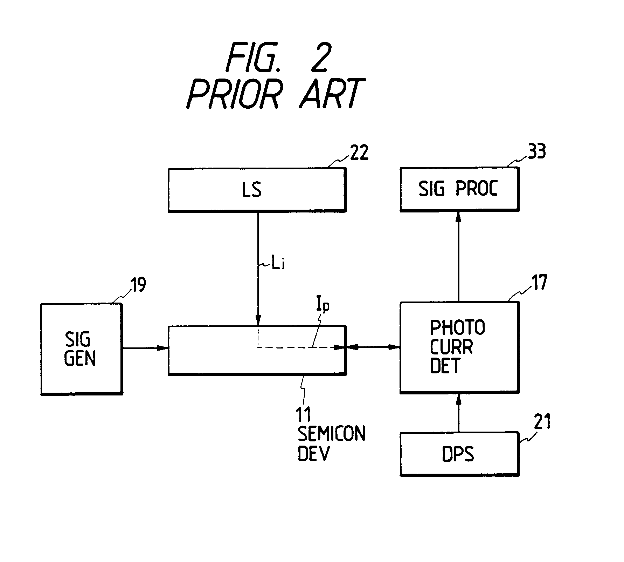

Fig. 2 is a block diagram showing the construction of a conventional noncontact laser probe;
Fig. 3 is a block diagram illustrating the construction of the charge-optical probe according to the present invention;
Fig. 4A is a graph showing the relationship between the carrier density and refractive index variations;
Fig. 4B is a graph showing the relationship between the carrier density and reflectance variations;
Fig. 5 is a schematic diagram showing a part of a semiconductor device used in experiments of the present invention;
Fig. 6 is a diagram showing the two-dimensional distribution of variations in the reflectance of the semiconductor device depicted in Fig. 5;
Fig. 7 is a graph showing the relationship of the reflectance variation of the semiconductor device to the output amplitude thereof;
Fig. 8 is a block diagram illustrating a second embodiment of the charge-optical probe according to the present invention;
Fig. 9 is a block diagram illustrating a third embodiment of the charge-optical probe according to the present invention;
Fig. 10 is a block diagram illustrating a fourth embodiment of the charge-optical probe according to the present invention;
Fig. 11 is a block diagram illustrating a modified form of the charge-optical probe according to the present invention;
Fig. 12 is a block diagram illustrating another modified form of the charge-optical probe according to the present invention;
Fig. 13 is a block diagram illustrating a first embodiment of the active matrix array inspection apparatus according to the present invention;
Fig. 14 is a block diagram showing an example of the noncontact probe for use in the Fig. 13 embodiment;
Fig. 15 is a waveform diagram for explaining the operation of the apparatus depicted in Fig. 13;
Fig. 16 is a waveform diagram for explaining a defect detecting operation;
Fig. 17 is a block diagram illustrating a second embodiment of the active matrix array inspection apparatus according to the present invention;
Fig. 18 is a block diagram illustrating a third embodiment of the active matrix array inspection apparatus according to the present invention; and
Fig. 19 is a waveform diagram for explaining the defect detecting operation of the Fig. 18 embodiment.

### DESCRIPTION OF THE PREFERRED EMBODIMENTS

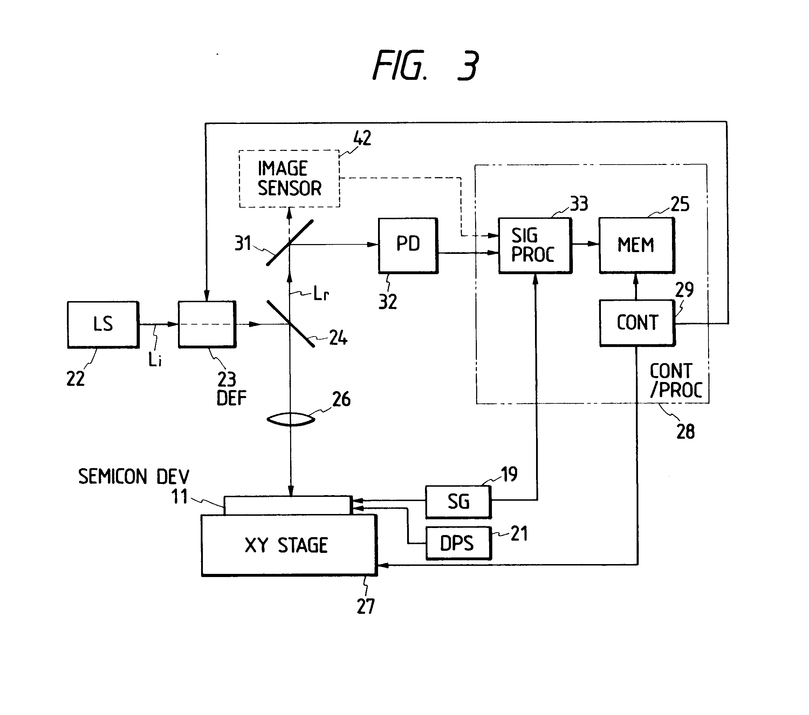

Fig. 3 illustrates in block form a first embodiment of the noncontact probe according to the present invention. The light beam Li from the light source 22 passes through an optical deflector 23 and is reflected by a semitransparent reflector 24 and is incident to the semiconductor device 11 through a condenser lens 26. The semiconductor device 11 is placed on an XY stage 27, which is placed under control of a controller (equipped with a control function) 29 of a control/processing unit 28 formed by an electronic computer. The XY stage 27 is controlled by the controller 29 to move the semiconductor 11 in the X-Y plane. The semiconductor device 11 operates on power from the drive power supply 21 and a signal from the signal generator 19.

The light beam Li incident to the semiconductor device 11 is reflected therefrom, the reflected light beam Lr passes through the condenser lens 26 and the semitransparent reflector 24 and is reflected by a reflector 31 and received by a photodetector 32, wherein the reflected light is converted to an electrical signal corresponding to its intensity. The electrical signal thus obtained is applied to a signal processor 33 (equipped with an information processing function) in the control/processing unit 28, wherein it is converted to electrical information of the semiconductor device 11 at the position where it was irradiated with the light beam Li. The electrical information is stored in a memory 25 corresponding to the position of irradiation, an elapsed-time input signal, etc., as required.

The light source 22 is one that emits light of a wavelength which does not generate electron-hole pairs in the semiconductor device 11 when incident thereto, such as a 1.3-αrn wavelength, continuous-wave, neodymium-doped yttrium lithium fluoride (Nd:YLF) laser. The optical deflector 23 is one that employs an acoustooptic element, by which the light beam Li for incidence to the semiconductor device 11 is deflected under control of the controller 29 so that the position of incidence to the semiconductor device 11 is finely set. The point of incidence of the light beam Li in the X-Y plane to the semiconductor device 11 is set by the optical deflector 23 and the XY stage 27, and though not shown, the point of reflection of the incident light beam in the Z-axis direction is also set. In this way, the light beam Li is applied to the preset spatial position in the semiconductor device 11.

Charges (or carriers) in the semiconductor device at the position of incidence of the light beam Li are plasma oscillating at the plasma frequency which is determined by the charge density. When the flow of carriers (or charges) in the semiconductor device 11 at the point of incidence is changed by the application thereto of a signal from the signal generator 19, the charge density at the point of incidence varies and the frequency of the plasma oscillation of the charges varies accordingly. For instance, the charge density in the emitter-base junction region of a bipolar transistor varies with a voltage which is applied across the junction.

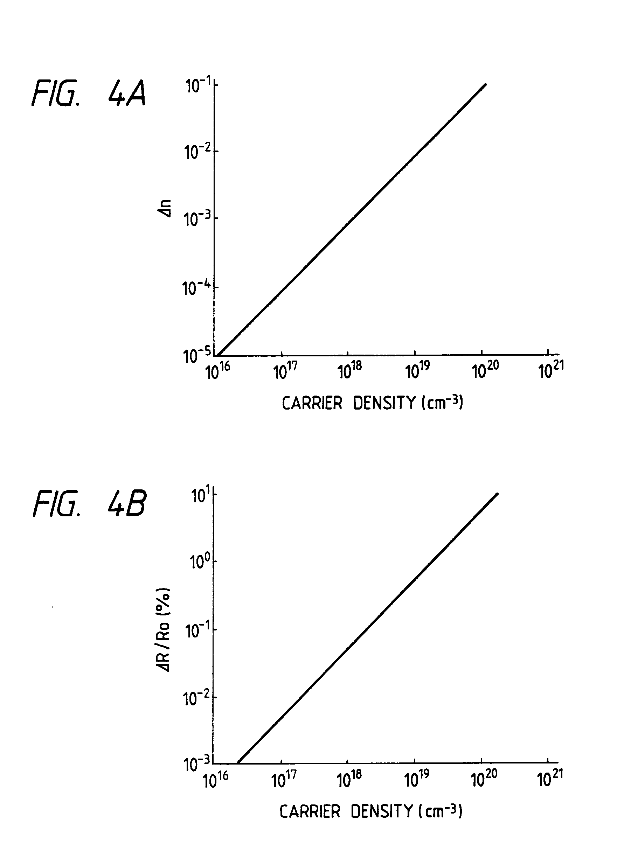

The refractive index at the point of incidence depends on the plasma oscillation frequency, that is, the charge density, and consequently, the reflectance at the point of incidence also depends on the charge density at that point. Fig. 4A shows the relationship between the carrier density in silicon and a variation An in its refractive index in the case of irradiating the silicon with light of a 1.3-µm wavelength. The variation An in the refractive index increases with an increase in the carrier density. Fig. 4B shows the relationship between a change in the carrier density in silicon and a change AR/Ro in the reflectance in the interface between silicon and silicon dioxide in the case of using the 1.3 µm laser light. As the carrier density increases, the reflectance change AR/Ro increases.

Hence, the intensity variation of the reflected light beam Lr corresponds to a change in the charge density at the point of reflection. The correspondence between the signal applied from the signal generator 19 to the semiconductor device 11 and the change in the charge density at the point of reflection, that is, electrical information (the operative state of the semiconductor device 11), is detected in the signal processing unit 33 and the detected output is stored in the memory 25.

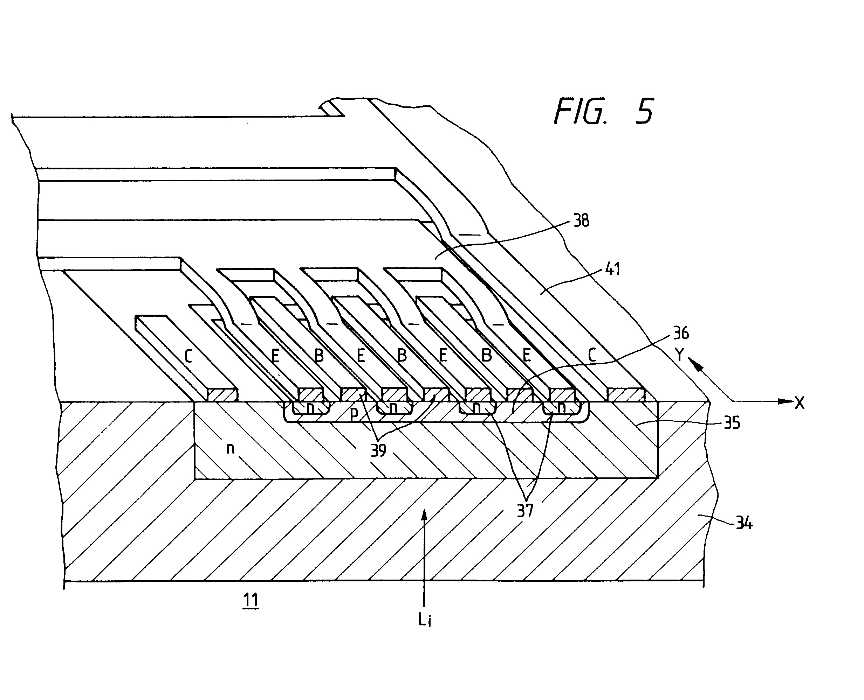

A 1.3-µm wavelength, continuous-wave, Nd:YLF laser was used as the light source 22, the light beam Li emitted from the light source 22 was reduced by the objective lens 26 to a spot size of about 2 j₁.m at the focal point on the semiconductor device 11, the power of the laser light incident to the semiconductor device 11 was as low as tens of uW, an inverting operational amplifier formed by a bipolar transistor in a silicon wafer was used as the semiconductor device 11, and a 1.2 kHz, 2.5 Vrms sine-wave signal was applied to the inverting operational amplifier. The silicon wafer was around 300 µm thick and the laser light Li was applied to the back of the silicon wafer to be focused into an image on the surface of the device. The points of reflection were measured by scanning the device surface with a resolution of 1 j1.m. Fig. 5 shows the construction of the bipolar transistor in the operational amplifier formed in the device 11. In a silicon wafer 34 there is formed a collector region 35, wherein a base region 36 is provided, and four long and narrow emitter regions 37 are formed side by side in the base region 36. Emitter electrodes 38 formed as a unitary structure are connected to the emitter regions 37 and base electrodes 39 are each connected to the base region 36 between adjacent emitter regions 37. A collector electrode 41 is connected to the collector region 35.

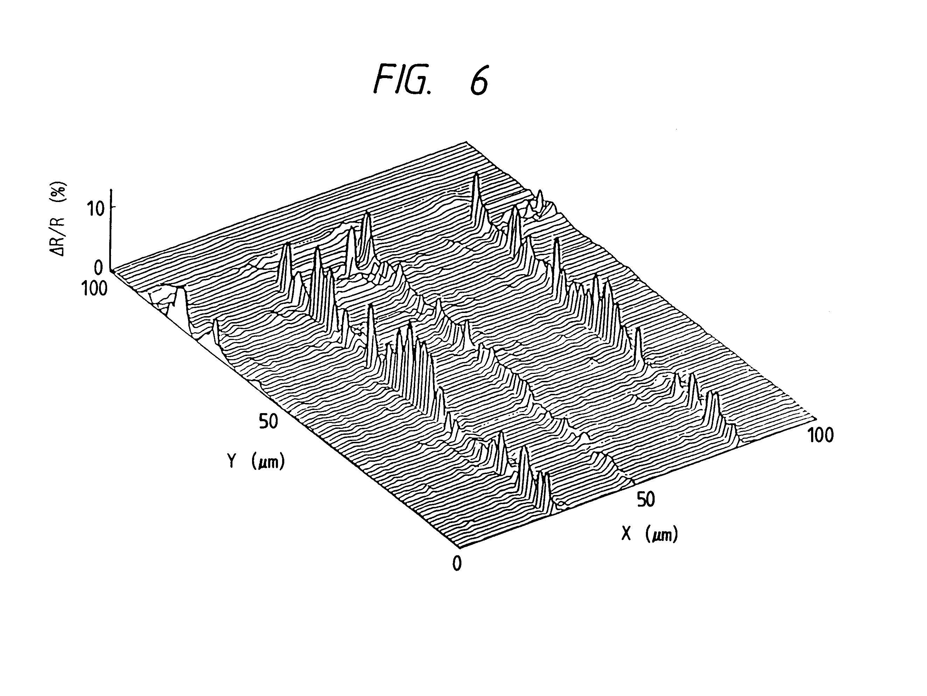

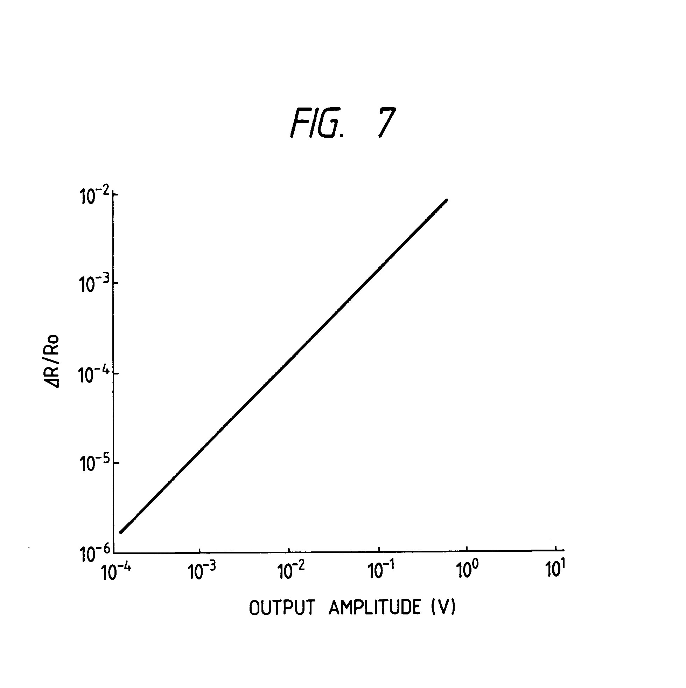

Fig. 6 shows a part of the two-dimensional distribution of measured results of the reflectance variation ΔR/R of the optical beam in the junction region between the base region (a p-type layer) 36 and each emitter region (an n-type layer) 37. The reflectance variation ΔR/R is large along long and narrow peaks extending along the junction region, from which it is seen that the charge density variation in the junction region is larger than in the surrounding regions. Fig. 7 shows the relationship between the output amplitude voltage of the inverting amplifier and the reflectance variation ΔR/R in the base-emitter junction region of the output stage of the amplifier in the case where the aforementioned sine-wave signal was input. As the amplitude of the input sine-wave signal increases, the output amplitude increases and the reflectance variation increases accordingly.

While in the Fig. 3 embodiment the intensity of the reflected light Lr from a very small point on the semiconductor device 11 is detected by the photodetector 32, it is also possible to adopt a construction in which the reflector 31 is omitted but instead the semiconductor device 11 is irradiated over a large area or the entire area of its surface with the light beam Li, the image of the irradiated surface is formed on the screen of a CCD or similar image sensor 42 indicated by the broken line in Fig. 3, the two-dimensional distribution of charges in the irradiated region is converted to an image signal and the image signal is applied to the signal processor 33.

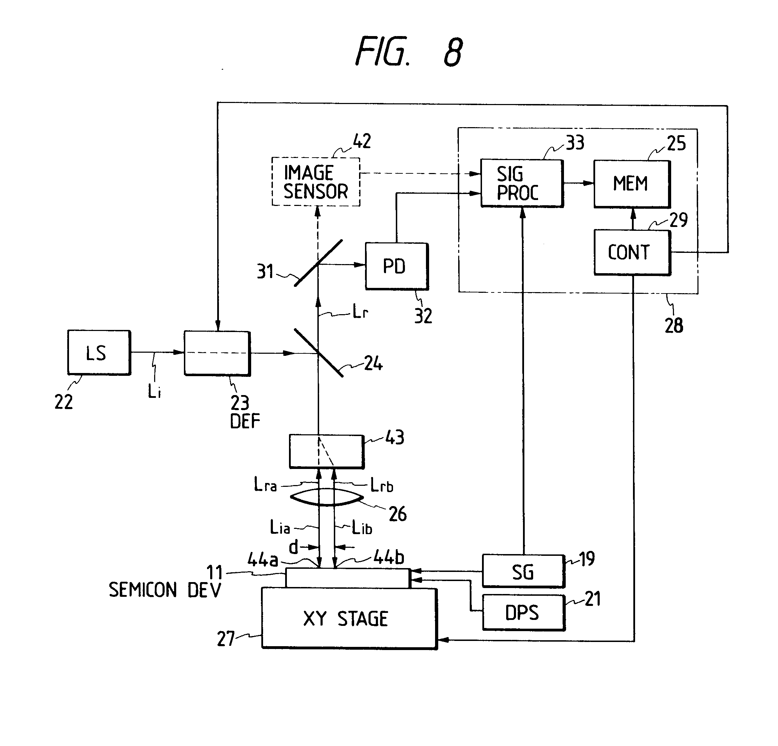

Fig. 8 illustrates in block form a second embodiment of the noncontact probe according to the present invention, in which the parts corresponding to those in Fig. 3 are identified by the same reference numerals. The Fig. 3 embodiment utilizes the phenomenon that the surface reflectance of the semiconductor device under test 11 depends on the charge density below the device surface, but the Fig. 8 embodiment utilizes a phenomenon that light which is incident to the semiconductor device under test, internally reflected therein and the emitted therefrom is phase shifted in accordance with the refractive index corresponding to the charge density in the passage in the semiconductor device. In this embodiment the light beam Li from the light source 22 is split into light beams Lia and Lib by a beam splitter 43 formed by a Savart plate, for instance, and the light beams Lia and Lib are applied to preset spatial positions 44a and 44b in the semiconductor device 11, respectively.

The incident light beams Lia and Lib, which have entered into the semiconductor device 11 at the positions 44a and 44b, are reflected by an internal boundary layer back to the beam splitter 43, wherein the reflected light beams Lra and Lrb are coupled into one light beam, that is, the reflected light beams are converted to an interference light beam Lr of an intensity corresponding to the phase difference between the reflected light beams Lra and Lrb, and the interference light beam Lr thus obtained is provided to the photodetector 32. Hence, the beam splitter 43 functions also as phase difference-to-intensity converting means. The electrical signal from the photodetector 32 is supplied to the signal processing part 33 in the control/processing unit 28. Since the velocity of light lowers with an increase in the refractive index of a medium, the phases (or velocities) of the reflected light beams Lra and Lrb correspond to the refractive indexes at the spatial positions 44a and 44b, that is, the charge densities at those points, respectively. It is possible, with the signal processing part 33, to detect the value of the charge density at the one position 44b relative to the charge density at the other position 44a, from which the relationship of the electrical state at the position 44a to the electrical state at the position 44b can be learned.

Now, let it be assumed, for example, that the position 44a is on the junction portion of a transistor forming one memory cell in a semiconductor memory and the position 44b on the corresponding junction portion of a memory cell at a certain distance d from the position 44a. (By turning the Savart plate 43 in its plane, memory cells on its radius d can be selected.) Signals "1" and "0" from the signal generator 19 are written into the memory cell concerned alone, repeatedly and alternately with each other, while the intensity of the interference light Lr is measured by the photodetector 32. By moving the positions 44a and 44b through driving of the optical deflector 23, the electrical state of each memory cell of the semiconductor device 11 can be detected. In this embodiment the reflected light beam Lrb serves as a reference light beam and may preferably be of about the same intensity as that of the light beam to be measured Lra.

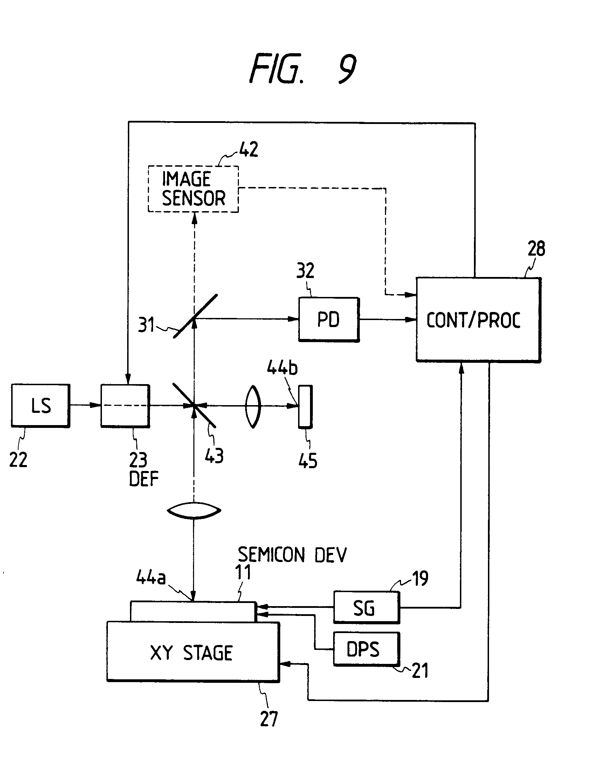

Fig. 9 illustrates in block form a third embodiment of the noncontact probe according to the present invention, in which the parts corresponding to those in Fig. 8 are identified by the same reference numerals. As is the case with the Fig. 8 embodiment, according to this embodiment, the phase of light (or optical path length) is varied with a change in the refractive index corresponding to the distribution of the charge density in the semiconductor device under test, the interference light intensity is changed accordingly, and this change is detected. That is, a reference element 45 is provided separately of the semiconductor device 11 under test, the light beam Li from the light source 22 is applied to the reference element 45 through the beam splitter 43 formed by a semitransparent mirror, the reflected light from the reference element 45 is used as reference light, which is coupled by the beam splitter 43 with the reflected light from the semiconductor device 11 to obtain the interference light Lr. The beam splitter 43 acts as phase difference-to-intensity converting means. The reference element 45 may be the same semiconductor device (but held inoperative) as that 11, the same silicon wafer as that on which the semiconductor device is formed, or a simple mirror. Also in this embodiment it is possible to adopt a construction in which an interference image of a wide irradiated region of the semiconductor device is formed by use of a light beam of a large spot size and the image is converted by the image sensor 42 into an image signal.

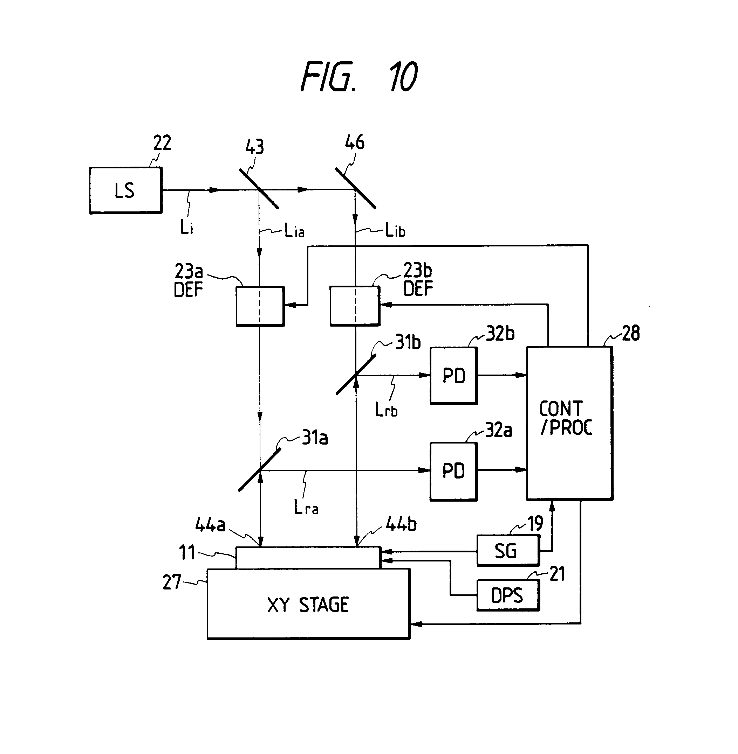

Fig. 10 illustrates in block form a fourth embodiment of the noncontact probe according to the present invention, in which the parts corresponding to those in Figs. 3, 8 and 9 are identified by the same reference numerals. The light beam Lia, one of the two light beams split by the beam splitter 43, is applied to the spatial position 44a on the semiconductor device 11 through an optical deflector 23a and a half mirror 31a, and the reflected light beam Lra is supplied to a photodetector 32a through the half mirror 31a. The other light beam Lib from the beam splitter 43 is reflected by a reflector 46 and is applied to the spatial position 44b on the semiconductor device 11 through an optical deflector 23b and a half mirror 31 b, and the reflected light beam Lrb is applied to a photodetector 32b through the half mirror 31b. The output electrical signals from the photodetectors 32a and 32b correspond to the charge densities at the positions 44a and 44b, respectively. Hence it is possible to obtain information corresponding to the relative value of the charge density at the position 44b on the basis of the charge density at the position 44a.

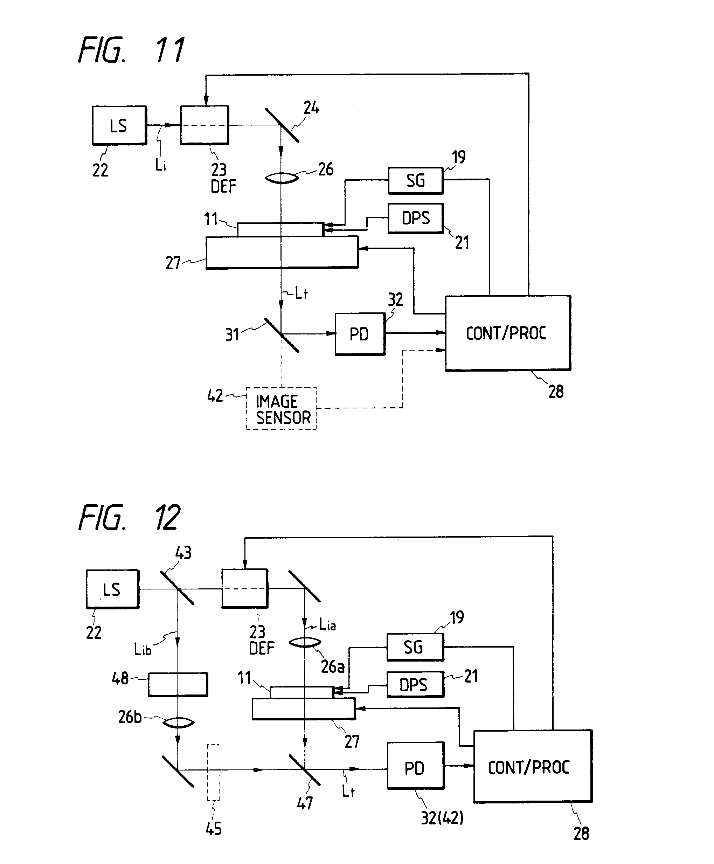

Although in the above, light is applied to the semiconductor device and the reflected light from its surface or inside is used to detect information corresponding to the charge density in the semiconductor device, the transmitted light may also be used because it is related to the refractive index. Fig. 11 illustrates a transmitted light measuring type probe which is a modification of the reflected light measuring type probe of the Fig. 3 embodiment which detects, as an intensity variation, a change in the surface reflectance which is caused by a change in the refractive index dependent on the charge density. In Fig. 11 the parts corresponding to those in Fig. 3 are identified by the same reference numerals but no description will be given thereof.

Fig. 12 also illustrates another example of the transmitted light measuring type probe, which is a modified form of the Fig. 8 or 9 embodiment which detects, as the interference light intensity, the phase difference which is caused by the refractive index distribution. In this embodiment the light beam from the light source 22 is split by the beam splitter 43 into two light beams Lia and Lib, the light beam Lia is applied to the semiconductor device 11 and the transmitted light therethrough and the light beam Lib are combined by a semitransparent mirror 47 into interference light Lt. In the optical path of the light beam Lib there is provided a phase adjuster 48, by which the phase of the light beam Lib is adjusted so that the interference state of the both light beams becomes optimum. The interference light Lt is detected by the photodetector 32 (or the image sensor 42). It is also possible to employ a construction in which a semiconductor device 45 identical in construction with the semiconductor device 11 is provided in the optical path of the light beam Lib, as indicated by the broken line, and the transmitted light through the device 45 is caused to interfere with the transmitted light from the semiconductor device 11.

The embodiments described above are each adapted to detect the information on the charge density variation at the point of incidence of light to the semiconductor device 11 while keeping it operative, but it is also possible to obtain electrical information related to the charge density at respective parts of the semiconductor device 11 without putting it into operation. Moreover, while in the above a continuous light beam is applied to the semiconductor device 11, the time resolution can be enhanced by irradiating the semiconductor device with a light pulse beam which is synchronized with the waveform of the signal from the signal generator 21.

As described above, according to the present invention, information corresponding to the charge density in a semiconductor device at the point of incidence of the light beam can be obtained, on the basis of which it is possible to decide not only the ON/OFF state of the semiconductor device but also its intermediate or transient state, and a resolution of at least 1 mV can be obtained.

With conventional laser probes, the time resolution is limited by a time lag until the photo current reaches the power supply circuit after excited electron-hole pairs diffuse in the semiconductor device under test. With the present invention, however, since the information corresponding to the charge density at the light incident point can be obtained immediately as a reflected light beam, the time resolution can be enhanced by using a light pulse beam and reducing its pulse width; in this instance, the smaller the pulse width, the higher the time resolution. The time resolution can be raised up to the order of femto-second (10-¹⁵ seconds) in which a photo-electron interaction takes place. Thus, a noncontact probe of high response speed can be implemented.

With the conventional laser probes, since electron-hole pairs are generated for measurement, that is, since the semiconductor device under test is perturbed, there is a possibility of the OFF state being mistaken for the ON state, but the present invention does not perturb the semiconductor device under test, and hence ensures correct measurements at all times. Furthermore, according to the present invention, even an element which is provided inside a semiconductor substrate, such as a three-dimensional IC, can be inspected, regardless of its thickness, by use of a light beam of an infrared wavelength which passes through the semiconductor.

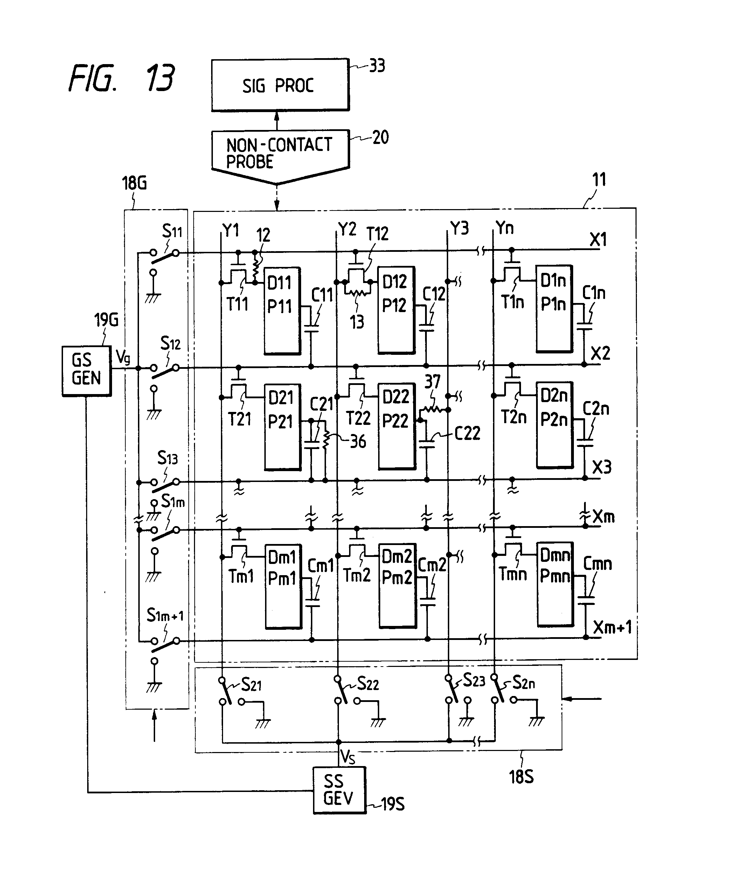

Fig. 13 illustrates a first embodiment of the active matrix array inspection apparatus according to the present invention which employs such a noncontact probe as mentioned above and in which the parts corresponding to those in Fig. 1 are identified by the same reference numerals. The present invention does not use the resistance measurement part 14 and the contact type test probe 16 shown in Fig. 1 but instead employ a gate signal generating part 19G, a source signal generating part 19S and a noncontact probe 20. The gate signal lines X₁ to Xm" are selectively connected to the output terminal of gate signal generating means 19S or grounding terminals by gate signal line select circuit 18G, that is, the switches S11 to S1 m + 1. The source signal lines Y₁ to Yₙ are selectively connected to the output terminal of source signal generating part 19S or grounding terminals by a source signal line select circuit 18S, that is, the switches S₂₁ to S₂ₙ. The gate signal generating part 19G and the source signal generating part 19S can each generate a fixed voltage signal or square-wave voltage signal of a fixed amplitude and are capable of changing the period of the square-wave voltage signal.

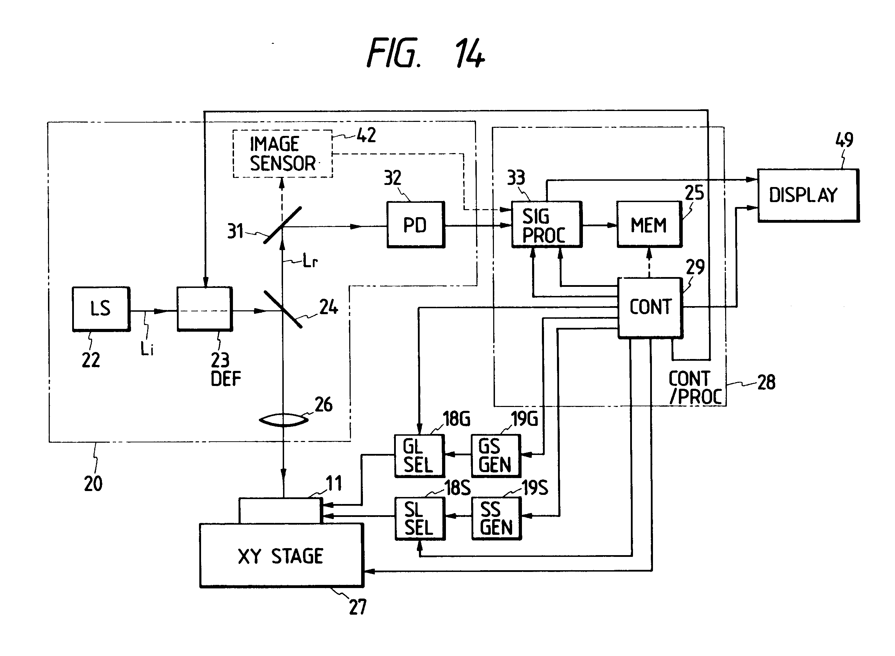

A description will be given of the case where the above-described optical charge probe is used as a noncontact probe 20 for detecting the electrical state of the drain terminal of an arbitrary thin film transistor in a noncontact manner. The optical charge probe 20 for use in the active matrix array inspection apparatus of Fig. 13 has such a construction as shown in Fig. 14, in which the laser light beam Li from the laser light source 22 passes through the optical deflector 23 and is reflected by the semitransparent reflector 24 and then condensed by the condenser lens 26 for incidence to the active matrix array 11. The active matrix array 11 is mounted on the XY stage 27. The controller (the control function) 29 of the control/processing unit 28 controls the XY stage 27 and the optical deflector 23 to set the position of incidence of the light beam Li in the X-Y plane in the active matrix array 11.

The wavelength of the laser light Li is chosen such that no electron-hole pair will be generated in the thin film transistor and since the refractive index of the semiconductor takes a value corresponding to the charge density in the semiconductor itself, the intensity of the reflected light beam Lr from the active matrix array 11 irradiated with the incident light beam Li corresponds to the refractive index or reflectance at the point of incidence to the active matrix array 11, and hence the reflected light intensity corresponds to the charge density at that point, that is, the electrical state (such as voltage). The reflected light beam Lr is condensed by the condenser lens 26 and reflected by the reflector 31 to the photodetector 32, wherein it is converted to an electrical signal. The controller 29 controls the generation of signals from the gate signal generating part 19G and the source signal generating part 19S and their voltage values and periods and effects selective control of the switches of the gate signal line select circuit 18G and the source signal line select circuit 18S.

The output electrical signal from the photodetector 32 is applied to the signal processing part 33, which detects the electrical state or condition at the point of incidence of the light beam Li and decides whether the thin film transistor (i.e. the pixel) is defective or not and the degree of the defect, on the basis of the output signal from the photodetector 32 and the applied gate and source signals. When the thin film transistor is decided as defective, the result of decision is displayed on a display 49, together with the location of the defect. If necessary, the result of decision or electrical information is stored in the memory 25 along with information on the position of incidence of the light beam.

Next, the detection of various defects will be described concretely. A description will be given first of a gate-drain shorting defect. Now, assume that there is a gate-drain short 12 in the thin film transistor T11 in Fig. 13. In this instance, the gate signal line X₁ and the gate signal generating part 19G are connected by the switch S11 alone and a high-level signal which has a suitable magnitude to such an extent as to turn on the thin film transistor is applied from the gate signal generating part 19G to the gate signal line Xi. All the gate signal lines, except the gate signal line Xi, are connected to the grounding terminals via the switches of the gate signal line select circuit 18G, except the switch Si ₁. All the switches of the source signal line select circuit 18S are connected to the grounding terminals, and hence all the source signal lines Y₁ to Yₙ are held grounded.

If the thin film transistor has no defect, then the drain terminal Dli (where i is an integer from 1 to n) of the thin film transistor Tli connected to the gate signal line X₁ and the pixel electrode Pli connected to the drain terminal Dli are held at the ground potential. Because of the presence of the gate-drain short 12 in the thin film transistor T11 connected to the gate signal line Xi, however, a signal is applied from the gate signal line X₁ via the shorting part 12 to the drain terminal D12 and the pixel electrode P11 connected thereto, putting them to a level intermediate between high and low levels which is dependent on the shorting resistance and the ON resistance (usually hundreds of kiloohms) of the thin film transistor T11. By detecting the electrical state or condition of the drain terminal D11 or pixel electrode P11 at such a level with the noncontact probe 20, the generation of the defect in the thin film transistor T11 is detected. Incidentally, the auxiliary capacitances C11 to Cmn are each formed opposite one of the gate signal lines by extending the semiconductor portion forming, for example, the drain, and the drain potential can be detected from the charge density in the electrode portion of the auxiliary capacitance.

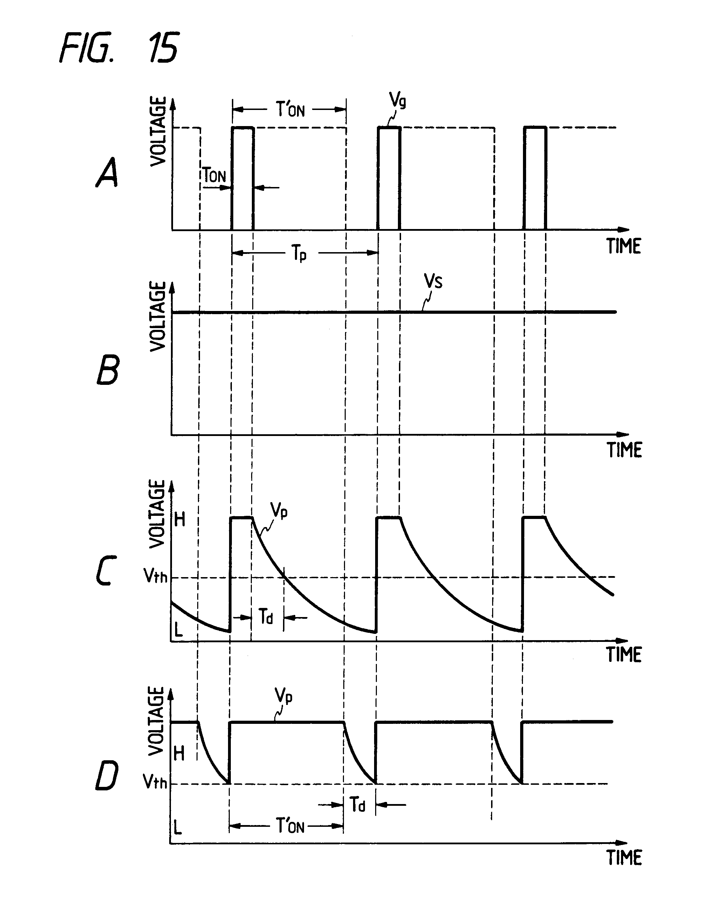

The state or condition of the defect of the thin film transistor T11, that is, the degree of the defect, can be detected in the following manner. The defect state is the state in which the shorting defect portion has a limited resistance value. In the case where the resistance value is very large, the thin film transistor can operate normally, and in the case of a complete short, the operation of the thin film transistor becomes abnormal. In the case of a high resistance ranging from several kiloohms to 1 megaohms, the display state of the pixel becomes somewhat abnormal. With the recent progress of the technique for reducing point and line defects in the display by active-matrix liquid-crystal display panels, it is becoming necessary to detect the high-resistance short as well, measure its state and improve the associated process. In the case of detecting this defect state, the gate signal generating part 19G and the gate signal line X₁ are connected via the switch and all the gate signal lines except that X₁ are grounded via the switches of the select circuit 18G, except the switch S₁₁. All the source signal lines Y_{;} (where j is an integer in the range of 1 to n) are connected to the source signal generating part 19S via the switches of the select circuit 18S. The gate signal generating part 19G is caused to generate a gate signal Vg which alternates a high-level voltage for turning ON transistors and a low-level voltage for turning OFF them, as shown on row A in Fig. 15, and the source signal generating part 19S is caused to generate a source signal Vs of a fixed voltage as shown on Row B in Fig. 15.

Now, let the cyclic period of the gate signal Vg and the time for which the transistor is held ON be represented by Tp and T_{ON}, respectively. In the case where there is such a shorting defect 12 as referred to previously, charges stored in the auxiliary capacitance C11 for the time during which the gate is closed, that is, during the OFF time of the transistor, Tp - T_{ON}, are discharged through the shorting part 12. Consequently, the potential Vp at the drain terminal D11 of the thin film transistor T11 and the potential Vp of the pixel electrode P11 connected to the drain terminal D11 are each caused by the gate signal Vg to alternate high and low levels with each other as depicted on Row C in Fig. 15. Since a voltage attenuation curve by the discharge during the OFF state of the transistor is dependent on a time constant which is determined by the auxiliary capacitance and the shorting resistance, the magnitude of the shorting resistance can be detected by measuring the time Td necessary for the pixel potential Vp to go down to a predetermined potential Vth after turning-OFF of the transistor T11.

In this case, the time T_{ON} for which the gate is held enabled is adjusted, as indicated by T'ON on Row D in Fig. 15 (or the period Tp is adjusted), so that the timing at which the pixel potential Vp attenuates down to the threshold potential Vth coincides with the start of the ON period T_{ON} as depicted on Row D in Fig. 15, and then the time Td is obtained from the time T'ON. Thus, the electrical state or condition of the drain terminal D11 of the thin film transistor T11 or the pixel electrode P11 connected thereto is detected by the noncontact probe 20, and the defective state of the shorting part 12 can be known from the values of the times T_{ON} and Tp at that time.

Next, a description will be made of the detection of a source-drain defect. Suppose that there is a source-drain short 13 in the thin film transistor T12 in Fig. 13. In this instance, all the gate signal lines X₁ to Xm" are grounded via the switches of the select circuit 18G, whereas all the source signal lines Y₁ to Yₙ are connected to the source signal generating part 19S via the switches of the select circuit 18S, and a high-level signal of a suitable magnitude, not zero, is applied to the source signal lines.

If all of the thin film transistors are defect-free, then their drain terminals and the pixel electrodes connected thereto will be low-level. Because of the presence of the source-drain defect in the thin film transistor T12, however, its drain terminal D12 and the pixel electrode P12 connected thereto go high-level. By detecting the electrical state or condition of the drain terminal D12 of the thin film transistor T12 or the pixel electrode P12 connected thereto in such a high-level state with use of the noncontact probe 20, the generation of the defect 13 in the thin film transistor T12 can be known.

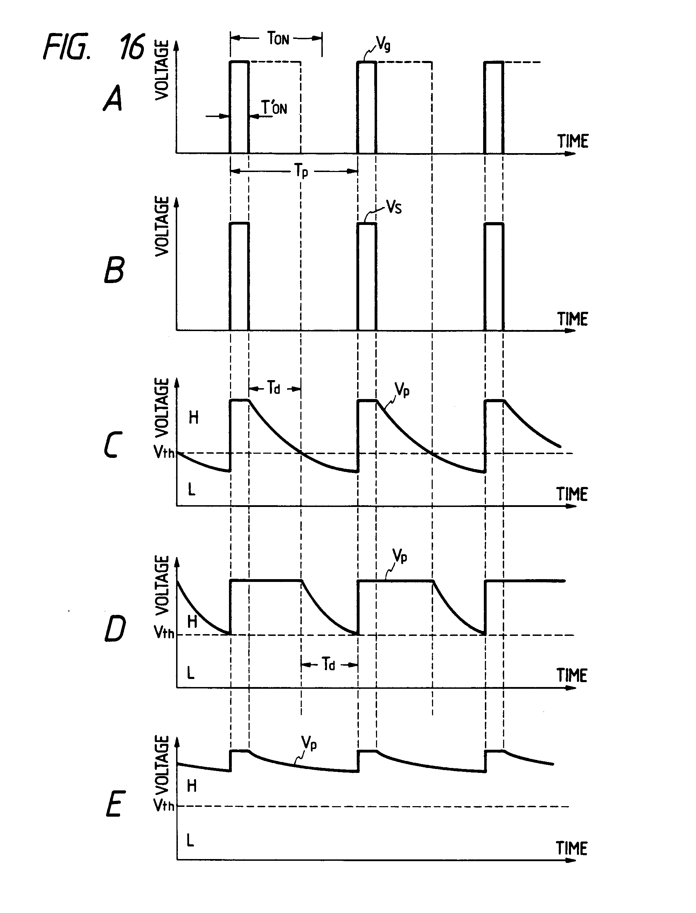

In the case of detecting the defective state of the thin film transistor T12, the gate signal line X₁ and the gate signal generating part 19G are connected via the switch S11 in Fig. 13 and the other gate signal lines are all grounded via the other switches of the select circuit 18G. Further, all the source signal lines Y₁ to Yₙ are connected to the source signal generating part 19S via the switches of the select circuit 18S. A gate signal Vg which alternates low and high levels with each other as shown on Row A in Fig. 16 is provided from the gate signal generating part 19G, and a source signal Vs which alternates high-level and low-level voltages in synchronization with the gate signal Vg as depicted on Row B in Fig. 16 is provided from the source signal generating part 19S.

Where the thin film transistor T12 has such a shorting defect 13 as mentioned above, charges stored in the auxiliary capacitance C12 are discharged for each low-level period. Consequently, the potential at the drain terminal D12 of the thin film transistor T12 or the potential Vg of the pixel electrode P12 connected thereto alternates high and low levels as depicted on Row C in Fig. 16. The timing for the potential Vp to reach the threshold potential Vth and the timing for starting the ON period of the transistor are brought into coincidence with each other by adjusting the ON period T_{ON} of the transistor or the period Tp of the gate signal Vg while observing the pixel potential Vp with the noncontact probe 20. The defective state can be known from the value of the period T_{ON} (or the period Tp).

Next, a description will be given of the detection of a shorting defect between the auxiliary capacitance and the gate signal line. Assume that there is a shorting defect between the auxiliary capacitance C21 and the gate signal line X₃ as indicated by 36 in Fig. 13. In this case, the gate signal line X₃ is connected via the switch S13 to the gate signal generating part 19G, from which is applied to the former a high-level signal of a proper magnitude. The other gate signal lines are all grounded via the corresponding switches of the select circuit 18G and all the source signal lines are grounded via the switches of the select circuit 18S. The potential at the drain terminal of each thin film transistor with no shorting defect and the potential of the pixel electrode connected to the drain terminal are low. However, the potential at the drain terminal D21 of the thin film transistor T21 and the potential of the pixel electrode P21 connected thereto are high, because of the shorting defect 36. The electrical state or condition of the drain terminal D21 of the thin film transistor T21 or pixel electrode P21 connected thereto is detected by means of the noncontact probe 20. By this, the generation of the shorting defect 36 between the auxiliary capacitance C21 and the gate signal line X₃ can be detected.

Next, a description will be given of the detection of a shorting defect between the auxiliary capacitance and the source signal line. In the case where there is a shorting defect between the auxiliary capacitance C22 and the source signal line Y₃ as indicated by 37 in Fig. 13, all the source signal lines Y₁ to Yₙ are connected to the source signal generating means 19S via the corresponding switches of the select circuit 18S and a high-level signal of a suitable magnitude is applied to all the source signal lines from the source signal generating part 18S. The gate signal lines X₁ to Xₘ₊₁ are all grounded via the corresponding switches of the select circuit 18G. In the absence of the shorting defect 37, the potential at the drain terminal of the thin film transistor and the potential of the pixel electrode connected thereto are low. Because of the presence of the shorting defect 37, however, the potential at the drain terminal D22 of the thin film transistor T22 and the potential of the pixel electrode P22 connected thereto are high. The electrical state or condition of the high-level potential drain terminal D22 of the thin film transistor T22 or potential of the pixel electrode P22 connected thereto is detected by the noncontact probe 22. Thus, the generation of the shorting defect 37 between the auxiliary capacitance C22 and the source signal line Y₃ can be detected.

The foregoing description has been given of the detection of various defects and measurement of their state (or magnitude). Next, a description will be given, with reference to Figs. 13 to 16, of methods for inspecting or checking the characteristics of normal or non-defective thin film transistors. For instance, in the case of checking the characteristic of the thin film transistor Tln, the gate signal line X₁ is connected via the switch S₁₁ to the gate signal generating part 18G and the other gate signal lines are all grounded via the corresponding switches of the select circuit 18G. On the other hand, the source signal lines are all connected to the source signal generating part 19S via the corresponding switches of the select circuit 18S. A gate signal Vg which alternates a high-level voltage and a low-level voltage as depicted on Row A in Fig. 16 is applied to the gate signal line Xᵢ, and at the same time, a source signal Vs which alternates a high-level voltage and a low-level voltage as depicted on row B in Fig. 16 is applied to all the source signal lines in synchronism with the application of the gate signal Vg. As a result, charges are stored in the auxiliary capacitance Cln and the potential at the drain terminal Dln of the thin film transistor Tln and the potential of the pixel electrode Pln connected thereto go high-level as shown on Row E in Fig. 16. Next, by gradually decreasing the ON time T_{ON} of the transistor Tln or increasing the period Tp, the potential at the drain terminal Dln of the thin film transistor Tln and the potential of the pixel electrode Pln connected thereto gradually come to alternate a high level and a low level owing to leak as shown on Row C in Fig. 16. By detecting, with the noncontact probe 20, such a state of the drain terminal Dln of the thin film transistor Tln or the pixel electrode Pln connected thereto, the characteristic of the thin film transistor Pln can be checked.

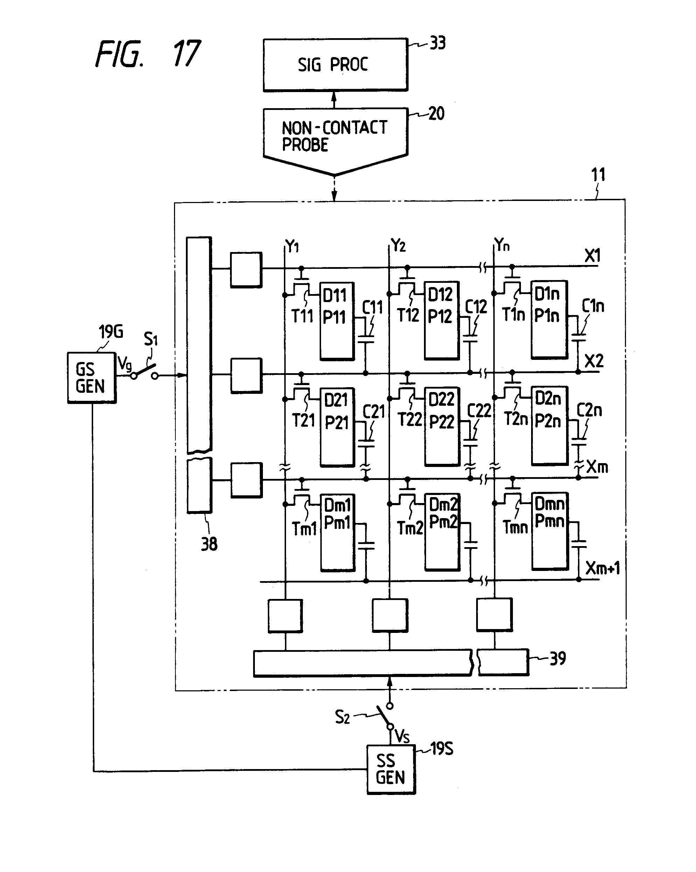

Fig. 17 illustrates a second embodiment of the active matrix inspection apparatus according to the present invention. The active matrix array 11 has shorting bars 38 and 39 which are provided on marginal portions of the substrate in the manufacturing process as measures against electrostatic destruction. (When assembling a liquid crystal panel, the shorting bars 38 and 39 are removed.) In this case, it is necessary that the active matrix array 11 be inspected with the shorting bars 38 and 39 attached thereto. In the case of checking the active matrix array 11 for the short 12 between the gate signal line and the drain electrode as shown in Fig. 13, the gate signal generating part 19G is connected via a switch S₁ to the shorting bar 38 which shorts the gate signal lines X₁ to Xₘ₊₁, and a switch S₂ is turned ON, through which the shorting bar 39 which shorts the source signal lines Y₁ to Yₙ is connected to the source signal generating part 19S. A high-level signal is applied from the gate signal generating part 19G to all of the gate signal lines X₁ to Xₘ₊₁, and a low-level signal is applied from the source signal generating part 19S to all of the source signal lines Y₁ to Yₙ. In this instance, the thin film transistor whose pixel electrode becomes high-level is regarded as defective.

In the case of detecting the source-drain short 13 depicted in Fig. 13, a low-level signal is applied from the gate signal generating part 19G to all of the gate signal lines X₁ to Xₘ₊₁ and a high-level signal is applied from the source signal generating part 19S to all of the source signal lines Y₁ to Yₙ. Also in this instance, the thin film transistor whose pixel electrode becomes high-level is regarded as defective. In the case of detecting the short 36 between the auxiliary capacitance C21 and the gate signal line X₃ in Fig. 13, a high-level signal is applied to all the gate signal lines X₁ to Xₘ₊₁ and a low-level signal is applied to all the source signal lines Y₁ to Yₙ, and the thin film transistor whose pixel electrode becomes high-level is regarded as defective. In the case of detecting the short 37 between the auxiliary capacitance C22 and the source signal line Y₃ in Fig. 13, a low-level gate signal is applied to all of the gate signal lines X₁ to Xₘ₊₁, a high-level source signal is applied to all of the source signal lines Y₁ to Yₙ, and the thin film transistor whose pixel electrode becomes high-level is regarded as defective. With this inspection method, however, it is impossible to distinguish the defects 12 and 36 from each other and the defects 13 and 37 from each other. When it is necessary to distinguish these defects, other inspection methods are used.

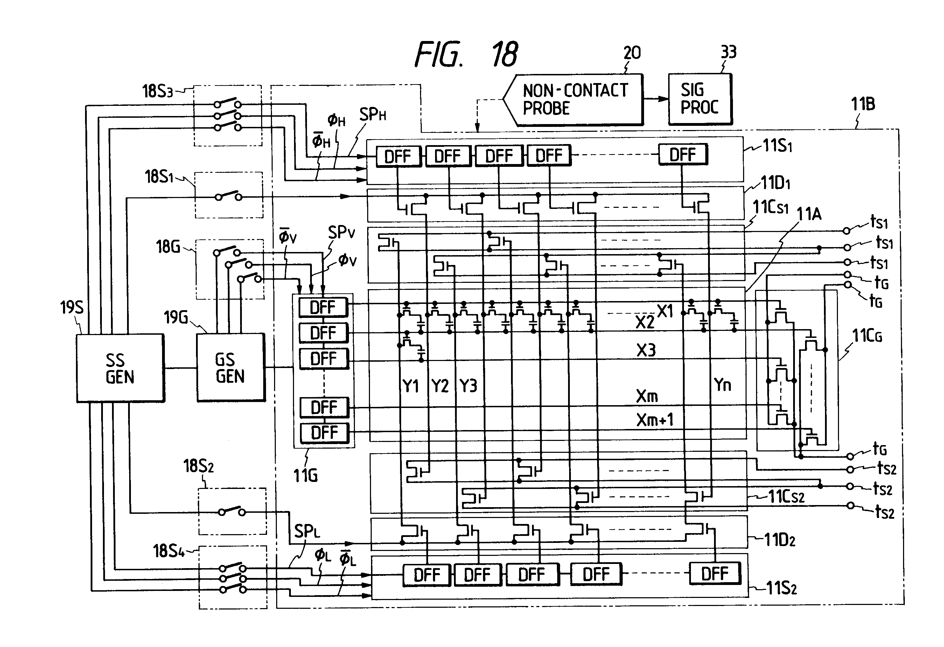

Fig. 18 illustrates a third embodiment of the active matrix array inspection apparatus according to the present invention. Some active matrix arrays are of the type wherein drivers for driving thin film transistors are built in the active matrix array substrate. For example, as shown in Fig. 18, a vertical shift register 11 G is formed in the substrate 11 B with the active matrix array 11A formed thereon and respective shift stages of the shift register 11 G are connected to the gate signal lines X₁ through Xₘ₊₁. Further, first and second horizontal shift registers 11S₁ and 11 S₂ are provided and their respective shift stages are connected to the gates of corresponding driving thin film transistors of first and second source line drivers 11D₁ and 11D₂. The driving thin film transistors of the first and second source line drivers 11D₁ and 11D₂ are each connected at the output end to an alternate one of the source signal lines Y₁ to Yₙ. In order that the active matrix array may be inspected by conventional contact probing for the breakage or shorting of the gate signal lines and source signal lines, a circuit 11C_{G} and terminals t_{G} are provided, and to enable a check to be made for the breakage and shorting of the source signal lines, circuits 11 C_{S1}, 11 C_{S2} and terminals tₛi, t_{S2} are provided.

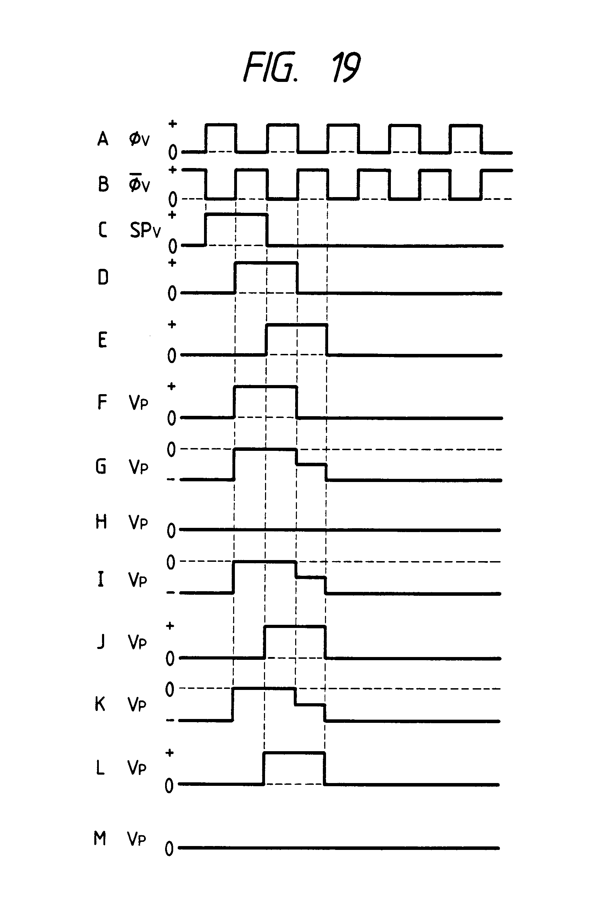

The gate signal generating means 19G generates 180° out-of-phase shift clocks Øᵥ and Ø̅ᵥ shown on Rows A and B in Fig. 19 and a start signal SPᵥ of one clock period width (one bit) depicted on Row C in Fig. 19. These signals are applied via the select circuit 18G to the corresponding input terminals of the vertical shift register 11G. The source signal generating part 19S generates two sets of signals (Ø₁, Ø̅₁, SP₁) and (Ø2, Ø̅2, SP₂) each composed of two shift clocks and one 1-bit start signal similar to those depicted on Rows A, B and C in Fig. 19. These signals are applied via switching circuits 18S₃ and 18S₄ to the corresponding terminals of the first and second horizontal shift registers 11S₁ and 11 S₂. Moreover, the source signal generating part 19S provides an image or picture signal (a mere high-level signal), which is applied via switching circuits 18S, and 18S₂ to the drains of the driving thin film transistors of the source line drivers 11D₁ and 11 D₂ in common to them. In short, the gate signal generating means 19G produces a signal for sequentially driving the gate signal lines X₁ to Xₘ₊₁ and the source signal generating means 19S produces a signal for sequentially driving the source signal lines Y₁ to Yₙ.

In the case of detecting the defect 13 shown in Fig. 13, the ground potential is applied via the switching circuits 18S, through 18S₄ to the horizontal shift registers 11 S₁, 11 S₂ and the sources of the respective driving thin film transistors of the source signal line drivers 11D₁, 11 D₂, by which the source signal lines Y₁ to Yₙ are grounded via channel resistances of those of the driving thin film transistors of the source line drivers 11D₁ and 11 D₂ which are in the ON state. Following this, the switching circuit 18G is closed, through which the signals Øᵥ, Ø̅ᵥ and SPᵥ shown on Rows A, B and C in Fig. 19 are applied from the gate signal generating part 19G to the vertical shift register 11 G, and as a result, signals such as depicted on Rows D and E in Fig. 19 are provided to the gate signal lines Xi, X₂, ..., Xₘ₊₁. At this time, the pixel electrode containing the defect 12 undergoes such a change in the potential Vp as shown on Row F in Fig. 19. The potential change of a normal pixel electrode without the defect 12 is such as shown on row G in Fig. 19. By monitoring the potential variation with the noncontact probe in synchronization with the start pulse SPy, a check can be made to see if the pixel electrode is normal or contains a short.

The setting of the conditions for detecting the defect 13 depicted in Fig. 13 is the same as in the case of detecting the defect 12. In this case, such signals as shown on Rows D and E in Fig. 19 are applied to the gate signal lines Xi, X₂, ..., Xₘ₊₁. The pixel electrode associated with the defect 13 undergoes substantially no potential variation as depicted on row H in Fig. 19, while the potential of a normal pixel electrode without the defect 13 changes as shown on Row I in Fig. 19. Hence, normal and shorted pixel electrodes can be distinguished by the same method as that for the detection of the defect 12.

The setting of the conditions for detecting the defect 36 in Fig. 13 is the same as in the case of detecting the defect 12. At this time, such signals as shown on Row D and E in Fig. 19 are applied to the gate signal lines X₂, X₃, ..., Xₘ₊₁. The pixel electrode containing the defect 36 causes such a change in the potential Vp as shown on Row J in Fig. 19. A normal pixel electrode without the defect 36 undergoes such a potential change as depicted on Row K in Fig. 19. Hence, normal and shorted pixel electrodes can be distinguished by the same method as that used for detecting the defect 12. As regards the distinction between the defects 12 and 36, when the potential change of the pixel electrode with a defect is in-phase with the signal which is applied to the gate signal line Xi, the defect is decided to be the defect 12, and when the potential change is in-phase with the signal which is applied to the gate signal line X₂, the defect is decided to be the defect 36.

In the case of detecting the defect 37 indicated in Fig. 13, the switching circuit 18G is opened, keeping the gate signal lines X₁ to Xm" grounded. The switching circuits 18S, and 18S₂ are closed, through which such signals as shown on Rows D and E in Fig. 19 are provided to the source signal lines Y₂ and Y₃. At this time, the pixel electrode associated with the defect 37 undergoes such a potential change as depicted on Row L in Fig. 19, while the potential of a normal pixel electrode without the defect 37 remains low as depicted on Row M in Fig. 19. Thus, normal and shorted pixel electrodes can be distinguished by the same method as that for detecting the defect 12.

In the above embodiments the ON time T_{ON} of the transistor or period Tp of the gate signal Vg is changed, but since the amount of charge stored in the auxiliary capacitance can be varied even by changing the gate voltage or source voltage, the characteristics of thin film transistors may also be inspected by such a method. While the foregoing embodiments have been described only in conjunction with the method for detecting various shorting defects, the present invention is not limited specifically thereto but allows ease also in checking active matrix arrays for disconnection defects such as the breakage of gate and source signal lines, breakage of thin film transistors and breakage of pixel electrodes. Moreover, in the above the noncontact probe 20 has been described to be a charge-optical probe, but it may also be substituted with an electro-optic probe (Japanese Patent Application Laid-Open Gazette No. 134584/90, for example) or electron beam probe of the type that measures secondary electrons released by the irradiation with an electron beam. While the present invention has been described as being applied to the inspection of the active matrix array which employ an additional capacitance system in which each auxiliary capacitance is connected at one end to the corresponding pixel electrode and at the other end to the gate signal line adjacent thereto, the invention is applicable as well to the inspection of an active matrix array of a storage capacitance system in which each auxiliary capacitance is connected at one end to the corresponding pixel electrode and at the other end to a common electrode.

As described above, the active matrix array inspection apparatus according to the present invention utilizes the noncontact probe, and hence is free from the possibility of damaging the surface of the thin film transistor or some other element. Moreover, the use of the noncontact probe precludes the possibility of leaving some of defects undetected owing to bad contact of the probe, and ensures their detection. Besides, since the light beam or electron beam is deflected in a nonmechanical fashion, it can be positioned at the point of detection with high speed, reducing the inspection time as a whole.

It will be apparent that many modifications and variations may be effected without departing from the scope of the novel concepts of the present invention.

## Claims

1. A charge-optical probe comprising:
a light source for emitting a light beam;
means for applying said light beam from said light source to a semiconductor device;
photodetector means for receiving reflected light or transmitted light of said light beam from said semiconductor device and for converting said reflected light or transmitted light to an electrical signal corresponding to its intensity; and
means for detecting, from said converted electrical signal, a signal corresponding to the charge density of said semiconductor device at the position of incidence thereto of said light beam.

2. A charge-optical probe comprising:
a light source for emitting a light beam;
beam splitting means for splitting said light beam from said light source into first and second light beams;
means for applying said first light beam to a semiconductor device;
reference light generating means for obtaining a reference light beam from said second light beam;
coupling means for coupling said first light beam from said semiconductor device and said reference light beam to obtain interference light;
photodetector means for receiving said interference light and for converting it to an electrical signal; and
means for detecting, from said converted electrical signal, a signal corresponding to the charge density of said semiconductor device at the position of incidence thereto of said first light beam.

3. The charge-optical probe of claim 2 wherein said reference light generating means is means whereby said second light beam is applied to a reference element and light output therefrom is provided as said reference light.

4. The charge-optical probe of claim 2 wherein said beam splitting means is formed by a Savart plate and said reference light generating mean is means whereby said second light beam from said Savart plate is applied to said semiconductor device and light output therefrom is provided as said reference light.

5. A charge-optical probe comprising:
a light source for emitting a light beam;
beam splitting means for splitting said light beam from said light source into first and second light beams;
means for applying said first and second light beams to first and second positions on a semiconductor device;
first and second photodetector means for receiving reflected or transmitted light beams from said first and second positions on said semiconductor device and for converting said reflected or transmitted light beams to first and second electrical signals, respectively; and
means for detecting, from said converted first and second electrical signals, the charge density of said semiconductor device at said first position relative to the charge density at said second position.

6. The charge-optical probe of claim 1, 2, or 5 wherein said photodetector means is an image sensor.

7. An inspection apparatus for an active matrix array including a matrix array of thin film transistors connected to gate signal lines and source signal lines, respectively, said apparatus comprising:
gate signal generating means;
source signal generating means;
gate signal line select means for selectively connecting each of said gate signal lines of said active matrix array under test to either one of an output terminal of said gate signal generating means and a grounding terminal;
source signal line select means for selectively connecting each of said source signal lines of said active matrix array under test to either one of an output terminal of said source signal generating means and a grounding terminal;
a noncontact probe for detecting the electrical state of a drain terminal of each of said thin film transistors connected to said gate signal lines and said source signal lines, without making contact with said each thin film transistor; and
means for deciding a characteristic of said each thin film transistor on the basis of the detected output from said noncontact probe.

8. An inspection apparatus for an active matrix array including gate line shorting means for shorting gate signal lines to one another, source line shorting means for shorting source signal lines to one another and a matrix array of thin film transistors connected to said gate signal lines and said source signal lines, respectively, said apparatus comprising:
gate signal generating means;
source signal generating means;
a gate switch for connecting said gate signal generating means to said gate line shorting means of said active matrix array;
a source switch for connecting said source signal generating means to said source line shorting means of said active matrix array;
a noncontact probe for detecting the electrical state of a drain terminal of each of said thin film transistors connected to said gate signal lines and said source signal lines, without making contact with said each thin film transistor; and
means for deciding a characteristic of said each thin film transistor on the basis of the detected output from said noncontact probe.

9. An inspection apparatus for an active matrix array including a matrix array of thin film transistors connected to gate signal lines and source signal lines, respectively, gate drive means for sequentially driving said gate signal lines, and source drive means for sequentially driving said source signal lines, said apparatus comprising:
gate signal generating means for generating a gate signal for activating said gate drive means to sequentially drive said gate signal lines;
source signal generating means for generating a source signal for activating said source drive means to sequentially drive said source signal lines;
gate switching means for connecting said gate signal generating means to or disconnecting it from said gate drive means;
source switching means for connecting said source signal generating means to or disconnecting it from said source drive means;
a noncontact probe for detecting the electrical state of a drain terminal of each of said thin film transistors connected to said gate signal lines and said source signal lines, without making contact with said each thin film transistor; and
means for deciding a characteristic of said each thin film transistor on the basis of the detected output from said noncontact probe.

10. The active matrix array inspection apparatus of claim 7, 8, or 9 wherein said noncontact probe includes: a light source for emitting a light beam; means for applying said light beam from said light source to said active matrix array; photodetector means for receiving reflected light or transmitted light from said active matrix array and converting said reflected or transmitted light to an electrical signal corresponding to its intensity; and means for detecting, from said converted electrical signal, a signal corresponding to the charge density of said active matrix array at the position of incidence thereto of said light beam.
